# EUROPÄISCHE PATENTANMELDUNG

(11) **EP 0 541 962 A2**
(43) Veröffentlichungstag der Anmeldung: **19.05.1993**
(21) Anmeldenummer: 92117287.0
(22) Anmeldetag: 09.10.1992
(51) Int. Cl.: H03G 3/00, G01D 1/14, H04R 3/00

(54) **Gehörschutz-Warnanzeige für ein elektroakustisches Wiedergabegerät**

(30) Priorität: 15.11.1991 DE 4137605
(71) Anmelder: GRUNDIG E.M.V. Elektro-Mechanische Versuchsanstalt Max Grundig holländ. Stiftung & Co. KG., D-90762 Fürth (DE)
(72) Erfinder: Keller, Klaus, Dipl.-Ing. (FH), Grundig E.M.V., Kurgartenstrasse 37, W-8510 Fürth/Bay (DE); Gelke, Klaus, Grundig E.M.V., Kurgartenstrasse 37, W-8510 Fürth/Bay (DE)

(57) **Zusammenfassung**

Den Forderungen von Verbraucherverbänden und Berufsgenossenschaften entsprechend soll die Wiedergabelautstärke von elektroakustischen Wiedergabegeräten, die vorzugsweise in Verbindung mit Kopfhörern betrieben werden, vom Gerätebenutzer bewußt so begrenzt werden können, daß auch bei langzeitigem Gebrauch keine Schädigung des menschlichen Gehörs auftritt.

Die vorliegende Erfindung beschreibt eine Warnanzeige, die mit geringem Aufwand in vorhandenen Geräten nachgerüstet werden kann, und die den Gerätebenutzer bei der Wahl einer individuellen Abhörlautstärke, auch in geräuscherfüllter Umgebung, nicht behindert.

## Beschreibung

Bei Geräten der Unterhaltungselektronik, insbesondere bei transportablen Geräten, die über Kopfhörer betrieben werden, wird in neuerer Zeit vermehrt die Forderung erhoben, den über den entsprechenden Schallwandler erzeugten Schalldruck auf ein für das menschliche Gehör erträgliches Maß zu begrenzen. Die gleiche Forderung gilt auch für die Wiedergabe von Diktataufzeichnungen in Schreibbüros, deren Beschäftigte einer erhöhten akustischen Belastung ausgesetzt sind.

Nach dem Stand der Technik ist es bekannt, transportable Cassettenspieler für Kopfhörerbetrieb mit einem Schalter zu versehen, mit dem die maximale Ausgangsleistung um einen festen Betrag reduziert werden kann. Ferner beschreibt die DE-OS 39 40 857 ein Verfahren zur Begrenzung der maximalen Lautstärke bei rechnergesteuerten Fernseh- und Tongeräten. Nach diesem Verfahren kann der Wert der maximal gewünschten Lautstärke über das Bedienteil dem geräteeigenen Rechner eingegeben werden, wobei die Dynamik des Ausgangssignals entsprechend komprimiert wird.

Nachteilig bei der erstgenannten Lösung ist, daß beim Abhören von Cassetten in geräuscherfüllter Umgebung stets nur mit der für maximale Lautstärke maßgebenden Schalterstellung gearbeitet werden kann, um eine ausreichende Verständlichkeit zu gewährleisten. In diesem Fall kann also der Benutzer weder erkennen, ob eine für sein Gehör unzuträgliche Lautstärke überschritten wird, noch wird er automatisch vor einem gehörschädigenden Schalldruck geschützt.

Das Verfahren nach der DE-OS 39 40 857 ist nur für aufwendige, mit geräteeigenem Rechner und elektronischer Dynamikkompression versehene Geräte geeignet. Neben dem erhöhten Aufwand an zusätzlicher Elektronik erweist sich als nachteilig, daß das Wiedergabesignal in seiner Dynamik komprimiert wird, was speziell bei der originalgetreuen Wiedergabe von Musik nicht erwünscht ist.

Ebenfalls nach dem Stand der Technik ist es bekannt, Leistungsverstärker mit Aussteuerungsanzeigen in Form von LED-Ketten oder LCD-Balkendiagrammen auszurüsten. Mit Hilfe dieser Anzeigen soll sichergestellt werden, daß die Verstärker nicht übersteuert werden, um den Klirrfaktor des Ausgangssignals für eine High-Fidelity-Wiedergabe zu begrenzen.

Aus der DE-OS 26 26 680 ist ebenfalls eine Lautstärke-Pegelanzeige-Einrichtung bekannt, die zum Einbau in Lautsprecherboxen vorgesehen ist und die allein vom NF-Eingangssignal der Lautsprecherbox gespeist wird. Die Anzeige bedient sich ebenfalls einer LED-Kette, wobei durch entsprechende Dimensionierung der Ansteuerglieder ein logarithmischer Anzeigenverlauf möglich ist.

Diese Aussteuerungsanzeigen sind jedoch nicht geeignet, den Gerätebenutzer durch ein eindeutig erkennbares Signal vor einer gehörgefährdenden Lautstärke zu warnen.

In der DE-OS 24 31 119 ist ferner eine Einrichtung offenbart, mit der die Stellung eines Funktionsstellers durch den Farbton oder die Farbkombination einer Leuchtdioden-Anordnung angezeigt werden soll. Die Normalstellung des Funktionsstellers soll dabei durch einen bestimmten Farbton oder durch die zeitgleiche Folge zweier wechselweise abgestrahlter, unterschiedlicher Farben gekennzeichnet werden. Zur Erzeugung spezieller Farbtöne wird entsprechend der vorgenannten Offenlegung das Licht zweier Leuchtdioden optisch gemischt, die geometrisch dicht nebeneinander montiert sind, so daß sie aus größerer Entfernung als homogene Lichtquelle erscheinen.

Die Auswertung des Farbtons bei gleitender Farbänderung ermöglicht jedoch keine exakte Grenzwertfestlegung. Außerdem kann die Stellung des Lautstärkestellers nicht als Maß für die absolut abgestrahlte Lautstärke herangezogen werden, da der Ausgangspegel eines Verstärkers nicht nur von der Stellung des Lautstärkestellers, sondern auch von der jeweiligen Eingangsspannung abhängig ist.

Es ist deshalb Aufgabe der Erfindung, eine Gehörschutz-Warneinrichtung für elektroakustische Wiedergabegeräte zu schaffen, die ein eindeutig erkennbares Signal beim Überschreiten eines vorgegebenen Ausgangspegels liefert, ohne den Gerätebenutzer daran zu hindern, die Lautstärke des abzuhörenden Signals den Erfordernissen des akustischen Umfeldes entsprechend individuell abzugleichen, und die ohne Änderung des äußeren Erscheinungsbildes in vorhandene Geräte nachträglich eingebaut werden kann.

Diese Aufgabe wird durch eine Anordnung nach Anspruch 1, 2, oder 3 gelöst. Anspruch 4 beinhaltet eine weitere Ausgestaltung der Erfindung.

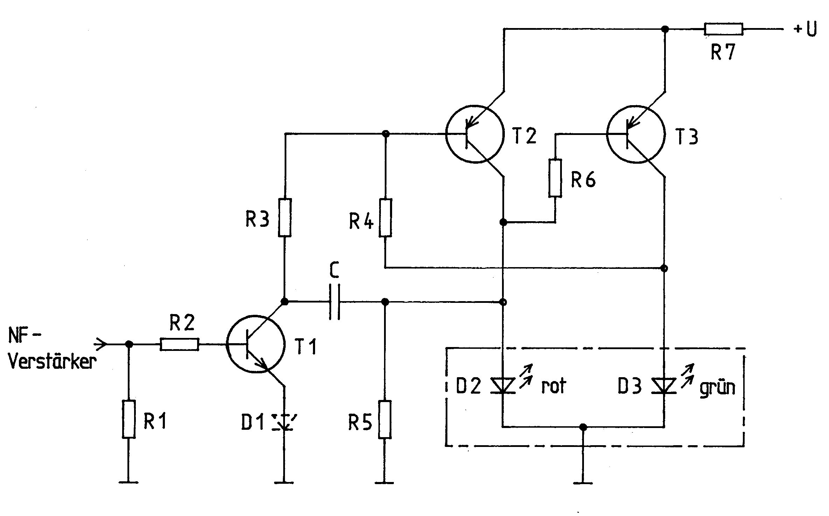

Anhand der beigefügten Zeichnung wird die Erfindung nachfolgend näher erläutert.

Die Figur zeigt das Ausführungsbeispiel einer Ansteuerschaltung, mit der ein Farbwechsel einer im Gerät vorhandenen Betriebsanzeige-LED bei Überschreiten eines festgelegten NF-Ausgangspegels erzeugt wird.

Solange vom NF-Verstärker keine Signalspannung geliefert wird, welche die für eine Halbwellengleichrichtung notwendige Schwellspannung, bestehend aus der Basis-Emitter-Spannung des Transistors T1 und der Kniespannung einer eventuell in Serie zum Emitter geschalteten Diode D1 übersteigt, bleibt der Transistor T1 und damit auch der Transistor T2 gesperrt, d.h., die rote Leuchtdiode D2 ist stromlos.

Die Basis der Transistors T3 ist über die Widerstände R5 und R6 auf Masse bezogen, wodurch dieser PNP-Transistor durchgeschaltet ist, da sein Emitter über R7 direkt mit der Spannungsquelle +U verbunden ist. Die grüne Leuchtdiode D3, die den Betriebszustand des Gerätes anzeigt, ist demzufolge stromdurchflossen, wobei der Diodenstrom durch den Widerstand R7 begrenzt wird.

Die Rückkopplung vom Kollektor T3 auf die Basis T2 über den Widerstand R4 stellt sicher, daß auch unter ungünstigen Reststrombedingungen der Transistor T2 ausreichend gesperrt bleibt.

Übersteigt nun die an der Basis des Transistors T1 eintreffende NF-Spannung die aus der Basis-Emitter-Strecke des Transistors T1 und einer eventuell in Serie geschalteten Diode D1 gebildete Schwellspannung, so wird der Transistor T1 und damit auch der Transistor T2 im Rhythmus der positiven Halbwellen durchgeschaltet, wobei unter der Voraussetzung, daß R7 << R5 ist, das Ansprechen der roten Leuchtdiode D2 über das. Integrationsglied C, R7 verzögert wird. Der Transistor T3 und damit der Stromfluß durch die grüne Leuchtdiode D3 wird jedoch unverzögert gesperrt. Auf diese Weise wird ein sprungartiger Farbwechsel ohne Mischfarbenübergang erzeugt.

Unterschreitet die Amplitude der positiven Halbwelle an der Baisis des Transistors T1 wieder den vorbeschriebenen Schwellwert, so wird der Transistor T1 sofort, der Transistor T2 aber unter der Voraussetzung, daß R7 << R3 ist, entsprechend der Zeitkonstanten C ^{.} R3 verzögert gesperrt. Durch geeignete Dimensionierung von R3 und R7 wird erreicht, daß das Aufleuchten der roten Leuchtdiode D2 und das Abschalten der grünen Leuchtdiode D3 zwischen zwei positiven Halbwellen des NF-Signals erhalten bleiben.

Andererseits führen die Kollektor-Basis-Rückkopplungen über den Kondensator C bzw. den Widerstand R4 zu einem steilflankigen Umschalten zwischen den beiden Leuchtdioden D2 und D3.

Da die beiden Pellets der grünen und roten Leuchtdiode in einem gemeinsamen Gehäuse untergebracht sind, das im Vergleich zu einer normalen Leuchtdiode nur mit einem zusätzlichen Anschlußfuß versehen ist, kann die beschriebene Warnanzeige anstelle einer im Gerät bereits vorhandenen Betriebsanzeige eingesetzt werden. Sofern die Warnanzeige in einem neu zu konstruierenden Gerät verwendet werden soll, können auch zwei baulich getrennte Anzeigeelemente vorgesehen werden.

Anstelle eines abrupten Farbwechsels der Betriebsanzeige beim überschreiten einer kritischen Lautstärke kann die Signalisierung auch mit einer einfarbigen Anzeige durch den Wechsel von kontinuierlichem auf intermittierenden Betrieb erfolgen. Dazu bedarf es außer einer entsprechenden Ansteuerschaltung keiner weiteren Änderung am Gerät, da eine bestehende Betriebsanzeige unverändert übernommen werden kann.

Bei Geräten mit alphanumerischer oder symbolgekennzeichneter Betriebsanzeige (z.B. mit Hilfe eines LC-Displays) kann die Warnfunktion über eine Symbol-, Buchstaben- oder Ziffernänderung wahrgenommen werden, ohne daß das bestehende Anzeigeelement modifiziert werden muß. Selbstverständlich sind auch Kombinationen der vorstehend beschriebenen Lösungen möglich.

Die erfindungsgemäße Warneinrichtung weist gegenüber dem Stand der Technik den Vorteil auf, daß sie ein eindeutiges Warnsignal liefert, den Gerätebenutzer aber nicht bei der Einstellung einer individuellen Lautstärke behindert. Außerdem ist sie mit geringem Aufwand in bestehenden Geräten nachrüstbar, ohne daß sich die Bedienung des Gerätes dadurch ändert.

## Patentansprüche

1. Optische Warnanzeige für ein elektroakustisches Gerät zur vorzugsweisen Wiedergabe von Tonträgerinformationen über Kopfhörer, deren Lautstärke mit Hilfe elektro-mechanischer oder elektronischer Stellglieder beliebig veränderbar ist, wobei die Einstellung der Stellglieder aus der Position der mechanischen Bedienelemente oder über optoelektronische Anzeigemittel erkennbar sein kann, **dadurch gekennzeichnet,** daß das Überschreiten eines für eine vorgegebene Lautstärke maßgebenden Ausgangspegels durch den sprunghaften Farbwechsel einer geräteseitig vorhandenen Einschalt-Kontrolleuchte signalisiert wird, ohne dabei den Bereich der individuell einstellbaren Lautstärke einzuschränken.

2. Optische Warnanzeige nach Anspruch 1,
**dadurch gekennzeichnet,** daß statt der wechselfarbigen Einschalt-Kontrolleuchte eine einfarbige Betriebsanzeige verwendet wird, mit der das Überschreiten eines für eine vorgegebene Lautstärke maßgebenden Ausgangspegels durch den sprunghaften Wechsel von kontinuierlichem auf intermittierenden Betrieb signalisiert wird.

3. Optische Warnanzeige nach Anspruch 1,
**dadurch gekennzeichnet,** daß statt der wechselfarbigen Einschalt-Kontrolleuchte eine alphanumerische oder symboldarstellende Betriebsanzeige verwendet wird, mit der das Überschreiten eines für eine vorgegebene Lautstärke maßgebenden Ausgangspegels durch den Wechsel des dargestellten Kennzeichens signalisiert wird.
